Europäisches Patentamt

European Patent Office

Office européen des brevets

(11) Veröffentlichungsnummer: **0 291 755**
**A1**

## (12) EUROPÄISCHE PATENTANMELDUNG

(21) Anmeldenummer: 88107037.9

(22) Anmeldetag: 03.05.88

(51) Int. Cl.⁴: **G01R 27/18**

(30) Priorität: 14.05.87 DE 3716169

(43) Veröffentlichungstag der Anmeldung:
**23.11.88 Patentblatt 88/47**

(84) Benannte Vertragsstaaten:
**BE CH ES FR GB IT LI LU NL SE**

(71) Anmelder: **Klein, Schanzlin & Becker Aktiengesellschaft**
**Johann-Klein-Strasse 9**
**D-6710 Frankenthal(DE)**

(72) Erfinder: **Heumann, Anton**
**Salzburger Strasse 103**
**D-8500 Nürnberg(DE)**
Erfinder: **Kuch, Jürgen**
**Am Strandbad 1**
**D-6710 Frankenthal(DE)**

(54) **Verfahren und Einrichtung zur Prüfung eines Isolationswiderstandes.**

(57) Die Erfindung beschreibt ein Verfahren und eine Einrichtung zur Prüfung des Isolationswiderstandes eines elektrischen Verbrauchers. Dabei wird ein Arbeitswiderstand eines vom Netz getrennten elektrischen Verbrauchers mit einer durch einen Gleichspannungserzeuger aus dem Netz gewonnenen Gleichspannung beaufschlagt und die an einem Meßwiderstand anstehende Spannung mit mehreren Ansprechwerten verglichen sowie das Vergleichsergebnis angezeigt. Desweiteren besteht die Möglichkeit, durch mehrere Anzeigevorrichtungen und Schaltkontakte die einzelnen Isolationswiderstände mehrerer Verbraucher wahlweise zu prüfen. Die Prüfung ist automatisierbar und erfolgt vor jedem Einschalten und/oder nach jedem Ausschalten eines Verbrauchers.

Fig. 1

0 291 755

## Verfahren und Einrichtung zur Prüfung eines Isolationswiderstandes

Die Erfindung betrifft ein Verfahren gemäß dem Oberbegriff des Hauptanspruches.

Prüfgeräte, mit deren Hilfe in Industrienetzen die Isolation von elektrischen Verbrauchern geprüft wird und die in Verbindung mit einem Schutzleitersystem als Maßnahme gegen unzulässig hohe Berührungsspannungen angewendet werden, weisen Nachteile auf. Da zum einen das gesamte Netz geprüft werden muß, läßt sich auch nur die Summe aller Isolationswiderstände erfassen. Ein einzelner schadhafter Verbraucher ist damit nicht zu erkennen. Zum anderen ist an geerdeten Netzen das Meßverfahren nicht einsetzbar, da der Isolationswiderstand bei einer Erdung gegen Null verläuft.

Eine aus der DE-OS 30 22 150 bekannte Maßnahme sieht vor, bei Wechsel- und Drehstromnetzen die Messung des Isolationswiderstandes mittels eines Isolationswächters durchzuführen. Damit kann zwar eine Isolationsmessung des gesamten Netzes erfaßt werden, nachteilig dabei ist die fehlende Möglichkeit zur Fehlerlokalisierung. Zur gestaffelten Anzeige des festgestellten Isolationswiderstandes sind mehrere Auswerteeinheiten und Anzeigeinstrumente erforderlich.

VDE/VDI-Vorschriften schreiben eine zyklische Prüfung von Netzen und Verbrauchern vor. Zur gefahrlosen Durchführung der Isolationsmessung ist eine aufwendige und zeitintensive Trennung eines Verbrauchers vom Netz erforderlich.

Der Erfindung liegt die Aufgabe zugrunde, eine Möglichkeit zu schaffen, mit deren Hilfe der Isolationswiderstand einzelner, nicht ständig arbeitender Verbraucher in wenig aufwendiger Weise geprüft, eine Gefährdung der Isolation signalisiert und das Isolationsmaterial nicht durch überhöte Meßspannungspegel belastet werden kann. Die Lösung dieser Aufgabe erfolgt gemäß dem kennzeichnenden Teil des Hauptanspruches.

Das erfindungsgemäße Verfahren bietet die Möglichkeit, den Isolationswiderstand eines einzelnen Verbrauchers in verschiedenen Stufen anzuzeigen und damit die Möglichkeit zur frühzeitigen Erkennung einer Isolationsverschlechterung. Dadurch eventuell bedingte Betriebsstörungen oder Personenschäden können rechtzeitig erkannt und geeignete Gegenmaßnahmen eingeleitet werden.

Eine Ausgestaltung der Erfindung ermöglicht eine systematische Überwachung des Verbrauchers. Durch eine zwangsweise Prüfung vor jedem Einschalten und/oder nach jedem Ausschalten des Verbrauchers kann der Prüfvorgang automatisiert werden. Außerdem besteht mit einer anderen Ausgestaltung die Möglichkeit,mittels einer Umschalteinrichtung die einzelnen Isolationswiderstände verschiedener Verbraucher wahlweise zu prüfen.

Eine weitere Ausgestaltung, derzufolge bei Unterschreiten eines vorgebbaren Ansprechwertes das Steuerwerk ein Schließen der Einschaltkontake verhindert, stellt sicher, daß bei eventueller Unterlassung von Gegenmaßnahmen der Verbraucher nicht betrieben und somit Personen-oder Sachschäden ausgeschlossen werden.

Um bei Bedarf eine Püfung des Isolationswiderstandes vornehmen zu können, wie es beispielsweise nach längerer Nichtbenutzung des Verbrauchers von Vorteil sein kann, bietet sich eine vorteilhafte Ausgestaltung gemäß dem Anspruch 5 an. Damit kann ein Funktionstest des Isolationsprüfungsgerätes vorgenommen werden. Eine Fehlfunktion im Isolationsprüfungsgerät selbst ist damit rechtzeitig zu erkennen. Nach einer weiteren Ausgestaltung kann die Testeinrichtung auch den Isolationswiderstand direkt prüfen.

Zur Ausführung des erfindungsgemäßäen Verfahrens dient ein im Anspruch 7 beschriebenes Isolationsprüfungsgerät. Infolge der aus dem Netz gewonnenen Gleichspannung liegt an der zu prüfenden Isolation eine Spannung an, deren Masximalwert die im Versorgungsnetz bestehende Spannung nicht überschreitet. Damit werden die üblichen höheren Meßspannungen vermieden und eine Schädigung der Isolation beim Meßvorgang wird ausgeschlossen. Für eine einfache Ausführungsform der Erfindung wird eine Anzeigeeinrichtung, beispielsweise ein Spannungsmeßerät, zum Meßwiderstand parallel geschaltet.

Eine andere Ausgestaltung der Erfindung sieht vor, daß dem Meßwiderstand ein Spannungsbegrenzer parallel geschaltet und über einen Trennverstärker mit einem Steuerwerk verbunden ist. Mit Hilfe des Trennverstärkers, der durch einen Spannungsbegrenzer vor unzulässigen Spannungen geschützt ist, wird der am Meßwiderstand auftretende Spannungsabfall verstärkt. Das am Ausgang des Trennverstärkers anstehende, dem Spannungsabfall am Meßwiderstand proportionale Spannungssignal wird einem Steuerwerk zugeführt, wobei der Trennverstärker einen Übergang der am Meßwiderstand und Isolationswiderstand anliegenden gleichgerichteten Netzspannung zum Steuerwerk verhindert. Beim Steuerwerk kann es sich nach einer anderen Ausgestaltung der Erfindung auch um einen Mikroprozessor handeln. Weitere Ausgestaltungen der Erfindung sehen vor, daß der Zustand des Isolationswiderstandes durch ein oder mehrere optische Anzeigeeinrichtungen signalisiert werden oder daß das Steuerwerk mit Einrichtungen zur Fernüber-

2

tragung von Signalen versehen ist.

Die Anzeige des Isolationswiderstandes durch ein oder mehrere Anzeigeeinrichtungen ermöglicht seine Darstellung im Hinblick auf vorgegebene Ansprechwerte. Diese können entsprechend dem Bedarfsfall gewählt und verschiedenen Bedingungen zugeordnet werden. Mit Hilfe der Einrichtungen zur Fernübertragung von Signalen ist eine Anzeige des Isolationswiderstandes auch bei schlecht zugänglichen Verbrauchern möglich.

Ausführungsbeispiele der Erfindung sind in den Zeichnungen dargestellt und werden im folgenden näher beschreiben. Dabei zeigen die

Fig. 1 eine mit einem Netz sowie einem Verbraucher verbundene Isolationsprüfungseinrichtung und die

Fig. 2 eine mit zwei Verbrauchern verbundene und entsprechend erweiterte Isolationsprüfungseinrichtung.

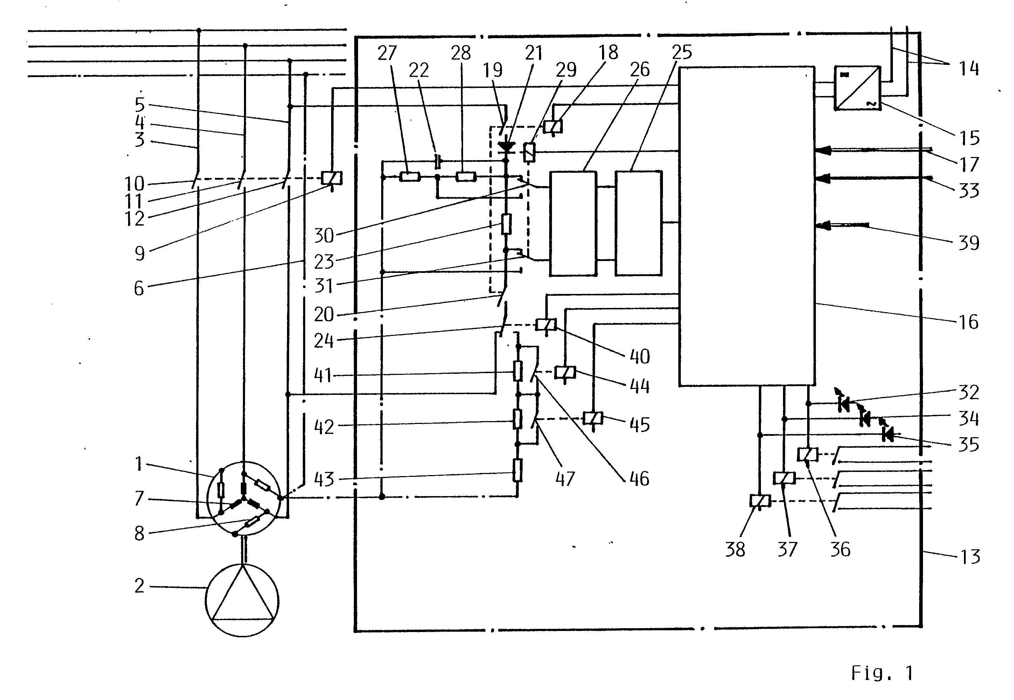

Die Fig. 1 zeigt einen Verbraucher (1), bei dem es sich beispielsweise um einen elektrischen Antriebsmotor einer Kreiselpumpe (2) handeln kann, dessen Phasen (3, 4, 5) sowie der strichpunktiert dargestellte Schutzleiter PE (6) mit einem Drehstromnetz verbunden sind. Der Verbraucher (1) weist eine Sternschaltung auf und zeigt den Arbeistwiderstand $R_1$ (7) der Motorwicklung sowie den zwischen Phase (5) und Schutzleiter PE (6) meßbaren Isolationswiderstand $R_{iso}$ (8). Dieser Isolationswiderstand $R_{iso}$ (8) besteht zwischen jeder Phase (3, 4, 5) und dem Schutzleiter PE (6).

Zum Einschalten des Verbrauchers (1) wird ein Relais (9) betätigt, mit dessen Hilfe Einschaltkontakte (10, 11, 12) die Stromversorgung zwischen den Phasen (3, 4, 5) und dem Verbraucher (1) sicherstellen.

Das in der Zeichnung dargestellte Isolationsprüfungsgerät (13) wird durch Leitungen (14) mit Eigenstrom versorgt, wobei unter Zwischenschaltung eines Netzgerätes (15) eine Strombeaufschlagung eines Steuerwerkes (16) erfolgt. Der Prüfungsvorgang läuft folgendermaßen ab: Wenn am Eingang (17) des Steuerwerkes (16) zur Anschaltung des Verbrauchers (1) ein Ein-Befehl ausgelöst wird, so setzt, bevor das Relais (9) angesteuert wird und die davon betätigten Einschaltkontakte (10, 11, 12) geschlossen werden, ein Prüfungsablauf ein. Dazu wird ein Schaltelement (18), hier ein Relais, geschaltet, dessen Kontakte (19, 20) einen elektrischen Stromkreis schließen.

Der Stromkreis umfaßt einen Gleichspannungserzeuger, bestehend aus einem mit einer Phase (5) verbundenden Gleichrichter (21) und einem Ladekondensator (22), die den Stromkreis schließenden Kontakte (19, 20, 24), einen Meßwiderstand $R_M$ (23) sowie den Isolationswiderstand $R_{iso}$ (8) und den Schutzleiter PE (6). Über dem Meßwiderstand $R_M$ (23) baut sich eine Gleichspannung auf, die dem Isolationswiderstand $R_{iso}$ (8) umgekehrt proportional ist. Diese Spannung wird einem Trennverstärker (25), zu dessen Schutz ein Spannungsbegrenzer (26) vorgeschaltet ist, zugeführt. Die Ausgangsspannung des Trennverstärkers (25) wird durch das Steuerwerk (16) mit vorgegebenen Grenzwerten verglichen.

Dieser Vergleich basiert darauf, daß bei einer einwandfreien Isolation eines Verbrauchers (1) der Isolationswiderstand $R_{iso}$ (8) einen wesentlich größeren Wert aufweist als der Arbeitswiderstand $R_1$ (7). Durch die Maßnahme, am Meßwiderstand $R_M$ (23) eine Gleichspannung $U_=$ anzulegen und den dort auftretenden Spannungsabfall zu erfassen, läßt sich folgendes Verhältnis ermitteln:

$$\frac{U_{M1}}{U_=} = \frac{R_M}{R_M + R_{iso}} \qquad \boxed{1}$$

Nach dieser Gleichung verhält sich die am Meßwiderstand $R_M$ (23) abfallende Spannung $U_{M1}$ zu der speisenden Gleichspannung $U_=$ wie das Verhältnis des Meßwiderstandes $R_M$ (23) zur Summe aus Meßwiderstand $R_M$ (23) + Isolationswiderstand $R_{iso}$ (8).

Die zur Bestimmung des Isolationswiderstandes $R_{iso}$ (8) erforderliche Gleichspannung $U_=$ wird mit Hilfe eines aus den Widerständen $R_{T1}$ (27) und $R_{T2}$ (28) bestehenden Spannungsteilers gemessen, wobei die Widerstände parallel zum Ladekondensator (22) geschaltet sind. Die den Spannungsteiler speisende Gleichspannung $U_=$ verhält sich zur am Widerstand $R_{T1}$ (27) abfallenden Spannung $U_T$ wie die Summe der Widerstände $R_{T1}$ (27) + $R_{T2}$ (28) zum Widerstand $R_{T1}$ (27).

$$\frac{U_=}{U_T} = \frac{R_{T1} + R_{T2}}{R_{T1}} \qquad \boxed{2}$$

Durch Umformungen der Gleichungen $\boxed{1}$ und $\boxed{2}$ ergibt sich eine Gleichung für den

3

Isolationswiderstand $R_{iso}$ (8)

$$R_{iso} = R_M \left( \frac{(R_{T1} + R_{T2})}{R_{T1}} \cdot \frac{U_T}{U_M} - 1 \right) \qquad \boxed{3}$$

Für den Auswertevorgang erfolgt ein Einschalten des von den Widerständen $R_{T1}$ (27) und $R_{T2}$ (28) gebildeten Spannungsteilers mittels eines Relais (29) sowie davon gesteuerte Umschaltkontakte (30, 31). Das Relais (29) erhält seinen Einschaltimpuls vom Steuerwerk (16).

Ergibt die Auswertung, daß der Isolationswiderstand $R_{iso}$ (8) des Verbrauchers (1) im "Gutbereich" liegt, so wird die Ansteuerung des Schaltelementes (18) zurückgenommen und durch das Einschaltrelais (9) die Einschaltkontakte (10, 11, 12) geschlossen. Das Ergebnis der Prüfung, demzufolge die Isolation einwandfrei ist, kann vom Steuerwerk (16) durch eine beispielsweise grüne Leuchtdiode (32) angezeigt werden.

Wenn dem im Betrieb befindlichen Verbraucher (1) ein Aus-Befehl über den Eingang (33) zugeführt wird, so schaltet das Steuerwerk (16) über das Relais (9) den Verbraucher (1) ab und setzt einen neuen Prüfungsablauf in Gang. Wird dabei festgestellt, daß der Isolationswiderstand $R_{iso}$ (8) einen Wert erreicht, der bereits in einem Bereich liegt, von dem eine Gefährdung zu erwarten ist, so wird die grüne Leuchtdiode (32) gelöscht und stattdessen eine andere, beispielsweise gelbe Leuchtdiode (34) angesteuert. Diese kann einen Toleranzbereich signalisieren, der im Übergang zwischen einem zulässigen und einem unzulässigen Isolationswiderstandswert liegt.

Wird bei der vergleichenden Messung jedoch festgestellt, daß sich der Isolationswiderstand $R_{iso}$ (8) so weit verschlechtert hat, daß ein Betrieb des Verbrauchers (1) nicht mehr zulässig ist, so wird nach erfolgtem Ein-Befehl und nach Ablauf des Prüfungsvorganges das Einschaltrelais (9) nicht betätigt und eine Gefahr signalisierende, beispielsweise rote Leuchtdiode (35) angesteuert. Zur Fernübertragung von Signalen werden mit den Leuchtdioden (32, 34, 35) in Verbindung stehende Relais (36, 37, 38) angesteuert

Unabhängig davon, ob der Verbraucher (1) eingeschaltet ist oder nicht, kann über eine Testtaste (39) das Steuerwerk (16) für einen Prüfablauf aktiviert werden. Es wird dazu zunächst, falls der Verbraucher (1) in Betrieb ist, das Relais (9) abgeschaltet und das Relais (18) angesteuert, so daß der vorerwähnte Prüfvorgang ablaufen kann. Durch ein nochmaliges Aktivieren der Testtaste (39), beispielsweise innerhalb eines bestimmten Zeitraumes, schließt ein Relais (40) den Schalter (24) und schaltet Simulationswiderstände (41, 42, 43) in den Meßkreis. Diese Simulationswiderstände (41, 42, 43) sind so dimensioniert, daß mit ihrer Hilfe Spannungen am Meßwiderstand $R_M$ (23) entstehen, die die verschiedenen Isolationszustände simulieren und der Funktionsüberprüfung dienen.

Mit Hilfe der Relais (44, 45) und Kontakte (46, 47) können die Simulationswiderstände (41, 42) wahlweise überbrückt oder mit dem Simulationswiderstand (43) in Reihe geschaltet werden. Die Testtaste (39) ermöglicht also zu jeder Zeit, vorausgesetzt, eine kurzfristige Prüfung hat keine nachteiligen Folgen für den Verbraucher (1), das damit verbundene Aggregat (2) oder einen davon abhängigen Prozeß, eine Prüfung des Isolationswiderstandes $R_{iso}$ (8) und eine Prüfung der Funktionsfähigkeit des Isolationsprüfungsgerätes (13). Nach dem Test wird automatisch auf die vorherige Betriebsart geschaltet.

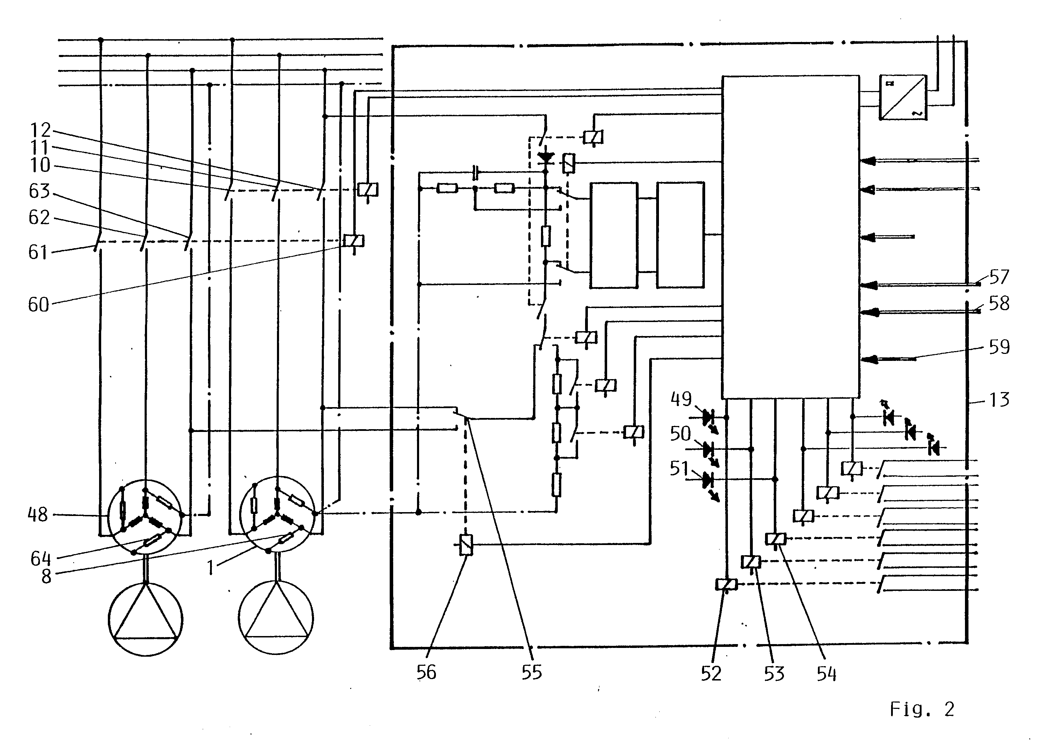

In der Fig. 2, die im Prinzip der Fig. 1 entspricht, ist ein Ausführungsbeispiel gezeigt, bei dem eine Prüfeinrichtung (13) zwei Verbraucher (1, 48) prüft. Zu diesem Zweck sind außer zusätzlichen Leuchtdioden (49, 50, 51) und mit ihnen in Verbindung stehenden Relais (52, 53, 54) noch ein Kontakt (55) mit einem Relais (56) vorhanden, wodurch die Möglichkeit des Umschaltens zwischen den zu prüfenden Verbrauchern (1, 48) gegeben ist. Der zusätzliche Verbraucher (48) wird über eine zweite Tastatur (57, 58, 59) angesteuert und durch ein Relais (60) mit den Einschaltkontakten (61, 62, 63) an das Netz geschaltet. Das Prüfverfahren des Isolationswiderstandes $R_{iso}$ (64) des zweiten Verbrauchers (48) läuft entsprechend der zur Fig. 1 geschilderten Ausführung ab.

**Ansprüche**

1. Verfahren zur Prüfung des Isolationswiderstandes eines elektrischen Verbrauchers, wobei dem Verbraucher zur Prüfung eine Gleichspannung aufgeschaltet und der damit ermittelte Zustand des Isolationswiderstandes angezeigt wird, **dadurch gekennzeichnet,** daß ein Arbeitswiderstand $R_1$ (7) eines vom Netz getrennten Verbrauchers (1) über einen Meßwiderstand $R_M$ (23) mit einer aus dem Netz gewonnenen Gleichspannung beaufschlagt wird und ein Vergleich zwischen der am Meßwiderstand $R_M$ (23) anstehenden Spannung mit mehreren festlegbaren Ansprechwerten erfolgt, wobei das Vergleichsergebnis optisch und/oder akustisch angezeigt wird.

2. Verfahren nach Anspruch 1, dadurch gekennzeichnet, daß vor jedem Einschalten und/oder nach jedem Ausschalten des Verbrauchers (1) mit Hilfe eines Steuerwerkes (16) und eines davon gesteuerten Schaltelementes (18) eine selbständige Prüfung des Isolationswiderstandes $R_{iso}$ (8) erfolgt.

3. Verfahren nach den Ansprüchen 1 und 2, dadurch gekennzeichnet, daß zur Messung einzelner Isolationswiderstände $R_{iso}$ (8, 64) mehrerer Verbraucher (1, 48) eine Umschalteinrichtung (55, 56) den Meßwiderstand (23) mit einem zu prüfenden Verbraucher (1, 48) verbindet.

4. Verfahren nach den Ansprüchen 1 bis 3, dadurch gekennzeichnet, daß bei Unterschreiten eines vorgegebenen Ansprechwertes das Steuerwerk (16) ein Schließen von Einschaltkontakten (10, 11, 12, 61, 62, 63) verhindert.

5. Verfahren nach den Ansprüchen 1 bis 4, dadurch gekennzeichnet, daß das Steuerwerk (16) mit einer Testeinrichtung (39) versehen ist und für Testzwecke anstelle des Isolationswiderstandes $R_{iso}$ (8, 64) ein oder mehrere Simulationswiderstände (41, 42, 43) eingeschaltet sind, der oder die aufgrund der Dimensionierung einen unterschiedlichen Isolationswiderstand simulieren und einen Funktionstest bewirken.

6. Verfahren nach Anspruch 5, dadurch gekennzeichnet, daß die Testeinrichtung den Isolationswiderstand $R_{iso}$ (8, 64) prüft.

7. Isolationsprüfungsgerät zur Durchführung des Verfahrens nach einem oder mehreren der Ansprüche 1 bis 6, dadurch gekennzeichnet, daß ein an einer Phase (5) eines Versorgungsnetzes leigender Gleichspannungserzeuger (21, 22) mit dem Meßwiderstand $R_M$ (23) in Reihe geschaltet, daß der Meßwiderstand $R_M$ (23) über Schaltkontakte (19, 20, 24) mit dem Arbeitswiderstand $R_1$ (7) und dem Isolationswiderstand $R_{iso}$ (8) verbindbar ist und daß dem Meßwiderstand $R_M$ (23) eine Anzeigeeinrichtung parallel geschaltet ist.

8. Isolationsprüfungsgerät nach einem oder mehreren der Ansprüche 1 bis 7, dadurch gekennzeichnet, daß einem Meßwiderstand $R_M$ (23) ein Spannungsbegrenzer (26) parallel geschaltet und über einen Trennverstärker (25) mit einem Steuerwerk (16) verbunden ist.

9. Isolationsprüfungsgerät nach einem oder mehreren der Ansprüche 1 bis 8, dadurch gekennzeichnet, daß den Zustand des Isolationswiderstandes $R_{iso}$ (8) ein oder mehrere optische Anzeigeeinrichtungen (32, 34, 35) signalisieren.

10. Isolationsprüfungsgerät nach einem oder mehreren der Ansprüche 1 bis 9, dadurch gekennzeichnet, daß das Steuerwerk (16) mit Einrichtungen (36, 37, 38) zur Fernübertragung von Signalen versehen ist.

11. Isolationsprüfungsgerät nach einem oder mehreren der Ansprüche 1 bis 10, dadurch gekennzeichnet, daß ein Mikroprozessor das Steuerwerk (16) bildet.

0 291 755

Fig. 1

Fig. 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | DD-A- 154 642 (G. SOBOLL) <br> * Seiten 1,4-5; Figur 2 * <br> --- | 1,2,11 | G 01 R 27/18 |
| X | DD-A- 130 808 (E.A. IVANOV et al.) <br> * Seite 8, Absatz 1 * <br> --- | 3 | |
| X | DE-A-3 122 042 (LICENTIA PATENT-VERWALTUNGS-GMBH) <br> * Zusammenfassung * <br> --- | 4 | |
| X | ELEKTROMEISTER, Band 22, Nr. 19, 1969, Seiten 1044-1049; A. WINKLER: "Isolationswächter in Krankenhäusern - Ja, aber wohin damit?" <br> * Seite 1045, Absatz: Wirkungsweise der Isolationswächter - Seite 1049; Figuren 2-4 * <br> --- | 5-10 | |
| D,A | DE-A-3 022 150 (MINTARD-ELEKTRONIK ENTWICKLUNG, LANUNG, FERTIGUNG GMBH) <br> * Ansprüche 1-8 * <br> --- | | |
| A | US-A-4 159 501 (O.C. WHITE) <br> * Zusammenfassung; Figur * <br> ----- | 1 | |

**RECHERCHIERTE SACHGEBIETE (Int. Cl.4)**

G 01 R 27/18

Der vorliegende Recherchenbericht wurde für alle Patentansprüche erstellt

| Recherchenort | Abschlußdatum der Recherche | Prüfer |
|---|---|---|
| BERLIN | 10-08-1988 | LEMMERICH J |